(19) Europäisches Patentamt
European Patent Office
Office européen des brevets

(11) EP 4 550 658 A1

(12) EUROPEAN PATENT APPLICATION

(43) Date of publication:
07.05.2025 Bulletin 2025/19

(51) International Patent Classification (IPC):
H02P 21/00 (2016.01)    G01R 31/34 (2020.01)
H02P 21/14 (2016.01)

(21) Application number: 23207987.1

(22) Date of filing: 06.11.2023

(52) Cooperative Patent Classification (CPC):
H02P 21/14; G01R 31/343; H02P 21/0025

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: VOLVO TRUCK CORPORATION
405 08 Göteborg (SE)

(72) Inventors:
• Jägerhag, Charlie
417 23 Göteborg (SE)
• Hall, Sebastian
413 17 Göteborg (SE)

(74) Representative: Ström & Gulliksson AB
P.O. Box 4188
203 13 Malmö (SE)

Remarks:
Amended claims in accordance with Rule 137(2)
EPC.

(54) **ELECTRICAL MACHINE IDENTIFICATION**

(57) A computer system comprising processing circuitry configured to determine a signal representing one or more peak values of an electrical current generated in an electrical machine, compare the signal to reference data corresponding to respective types of electrical machine, and determine a type of the electrical machine based on the comparison. A computer-implemented method, computer program product, and non-transitory computer-readable storage medium are also disclosed.

500

Determining a signal representing one or more peak values of an electrical current generated in an electrical machine — 502

Comparing the signal to reference data corresponding to respective types of electrical machine — 504

Determining a type of the electrical machine based on the comparison — 506

Apply control parameter settings to the electrical machine based on the determined type — 508

**FIG. 5**

**Description**

**TECHNICAL FIELD**

The disclosure relates generally to machine control. In particular aspects, the disclosure relates to electrical machine identification. The disclosure can be applied to heavy-duty vehicles, such as trucks, buses, and construction equipment, among other vehicle types. Although the disclosure may be described with respect to a particular vehicle, the disclosure is not restricted to any particular vehicle.

**BACKGROUND**

Electrical machines such as electric motors and generators are often controlled by controllers, such as microcontrollers. These controllers can be configured for the control of the specific electrical machine at issue, for example for embedded software control or monitoring in a vehicle. This can be achieved by installing a dataset onto the controller including control parameter settings that are specific to the type of electrical machine.

Generally, such a dataset is downloaded onto the controller after identifying the electrical machine. The machine can be identified based on, for example, information contained in a visual format (such as a barcode) displayed on the machine, or a memory device such as an electrically erasable programmable read-only memory (EEprom) attached to the machine. However, there may be operational situations where it is not favorable to download a dataset in this way, for example in cases where there is poor data connectivity. Furthermore, identifying an electrical machine in the ways currently practiced requires additional hardware which may not always fulfill the safety requirements of the particular application, or manual identification which is prone to human error.

There is therefore a need for alternative approaches to electrical machine identification that aim to solve, mitigate, alleviate, or eliminate at least some of the above or other disadvantages.

**SUMMARY**

This disclosure provides systems, methods and other approaches for determining a type of an electrical machine based on a signal representing an electrical current generated in the electrical machine. According to some typical examples, each type of electrical machine may have a characteristic current response to a voltage input that can be used to identify the machine. By using a current generated in the electrical machine, the type of machine can be identified based on sensor signals that are already available for control purposes. A control loop that might already be in place in the controller software can be employed for this, meaning there is no significant extra load on the hardware. The identification can be performed at standstill (without any torque generation), which makes it ideal for both end-of line testing or when the machine is installed in the vehicle.

Once the type of electrical machine is identified, an appropriate dataset for the controller can be selected, for example from a number of preloaded or downloaded datasets. According to some typical examples, if the signals are considered to meet the relevant safety standard, then the identification will in turn be considered safe, which ensures that the correct dataset is properly selected. This can be especially useful in safety critical applications where the integrity of the parameter choice is typically of utmost importance.

According to a first aspect of the disclosure, there is provided a computer system comprising processing circuitry configured to receive a signal representing one or more peak values of an electrical current generated in an electrical machine, compare the signal to reference data corresponding to respective types of electrical machine, and determine a type of the electrical machine based on the comparison.

The first aspect of the disclosure may seek to provide accurate identification of a type of electrical machine using existing hardware. The determination of a current response can be performed robustly and in a simple manner by applying a number of voltage pulses. The timing and magnitude of the voltage pulses can be tailored to provide different information about the current response of the machine, providing a yet more robust identification. The use of existing hardware can remove the need for additional components and/or infrastructure, and ensures that the relevant safety requirements are met. Application of this approach may also avoid any manual identification which is prone to human error.

Optionally in some examples, including in at least one preferred example, the signal represents a single peak value of an electrical current generated in the electrical machine. A technical benefit may include provide a quick approach to electrical machine identification that reduces wear in the machine.

Optionally in some examples, including in at least one preferred example, the signal represents a plurality of peak values of an electrical current generated in the electrical machine. A technical benefit may include providing more reliable results and/or a more robust identification (e.g., compared to using a single peak value).

Optionally in some examples, including in at least one preferred example, the processing circuitry is further configured to determine an average peak value of the plurality of peak values, and compare the average peak value to the reference data. A technical benefit may include ensuring that any anomalous values are compensated for and not given too high an influence on the result.

Optionally in some examples, including in at least one preferred example, the reference data comprises one or more sets of reference data, wherein each set of reference data corresponds to a respective type of electrical machine. A technical benefit may include enabling confirmation of an already-known machine type of the electrical machine, or identification of a type of the electrical machine from a number of different types.

Optionally in some examples, including in at least one preferred example, the processing circuitry is further configured to compare the signal to a plurality of sets of reference data, and determine a set of reference data of the plurality of sets of reference data having a smallest difference to the signal. A technical benefit may include enabling the most accurate match for the machine type to be determined.

Optionally in some examples, including in at least one preferred example, each set of reference data comprises at least one scalar current value corresponding to at least one scalar voltage value and/or at least one characteristic curve of a current response to one or more voltage pulses. A technical benefit of using scalar current values may include enabling a quick and easy comparison to be performed. A technical benefit of using characteristic curves may include enabling the effect of the resistance and inductance of the machine to be included, thus providing further distinction between different types of electrical machine.

Optionally in some examples, including in at least one preferred example, the processing circuitry is further configured to apply one or more reference voltage pulses to the electrical machine to generate the current in the electrical machine. A technical benefit may include enabling the response of the electrical machine to be compared to known and/or expected responses.

Optionally in some examples, including in at least one preferred example, the processing circuitry is configured to apply the one or more reference voltage pulses to the electrical machine such that the electrical machine does not generate torque. A technical benefit may include enabling the approach to be used during end-of line testing or when the electrical machine is installed in a vehicle, and reducing wear in the electrical machine.

Optionally in some examples, including in at least one preferred example, the processing circuitry is configured to determine the signal based on an output from at least one sensor associated with the electrical machine. A technical benefit may include that the approach can be applied using sensor signals that are already available, reducing the need for additional hardware and/or infrastructure.

Optionally in some examples, including in at least one preferred example, the processing circuitry is further configured to apply control parameter settings to the electrical machine based on the determined type. A technical benefit may include ensuring that the correct settings for the identified machine type are applied.

According to a second aspect of the disclosure, there is provided a vehicle comprising the computer system of the first aspect. The second aspect of the disclosure may seek to provide a vehicle with improved control of electrical machines.

According to a third aspect of the disclosure, there is provided a computer-implemented method comprising receiving, by processing circuitry of a computer system, a signal representing one or more peak values of an electrical current generated in an electrical machine, comparing, by the processing circuitry, the signal to reference data corresponding to respective types of electrical machine, determining, by the processing circuitry, a type of the electrical machine based on the comparison.

The third aspect of the disclosure may seek to provide accurate identification of a type of electrical machine using existing hardware. The determination of a current response can be performed robustly and in a simple manner by applying a number of voltage pulses. The timing and magnitude of the voltage pulses can be tailored to provide different information about the current response of the machine, providing a yet more robust identification. The use of existing hardware can remove the need for additional components and/or infrastructure, and ensures that the relevant safety requirements are met. Application of this approach may also avoid any manual identification which is prone to human error.

According to a fourth aspect of the disclosure, there is provided a computer program product comprising program code for performing, when executed by processing circuitry, the computer-implemented method of the third aspect. The fourth aspect of the disclosure may seek to provide program code for improving control of electrical machines. A technical benefit may include that new vehicles and/or legacy vehicles may be conveniently configured, by software installation/update, to control electrical machines in an improved manner.

According to a fifth aspect of the disclosure, there is provided a non-transitory computer-readable storage medium comprising instructions, which when executed by processing circuitry, cause the processing circuitry to perform the computer-implemented method of the third aspect. The fifth aspect of the disclosure may seek to provide program code for improving control of electrical machines. A technical benefit may include that new vehicles and/or legacy vehicles may be conveniently configured, by software installation/update, to control electrical machines in an improved manner.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

**FIG. 1** is a schematic diagram of a vehicle system according to an example.
**FIG. 2** schematically shows an electrical machine and a controller in the form of functional blocks, according to an example.
**FIG. 3** is an example plot of the current response for a plurality of voltage pulses for a first type of electrical machine.
**FIG. 4** is an example plot of the current response for a plurality of voltage pulses for a second type of electrical machine.
**FIG. 5** is a flow chart of a computer-implemented method according to an example.
**FIG. 6** is a schematic diagram of a computer system for implementing examples disclosed herein.

Like reference numerals refer to like elements throughout the description.

## DETAILED DESCRIPTION

The detailed description set forth below provides information and examples of the disclosed technology with sufficient detail to enable those skilled in the art to practice the disclosure.

In many operations, electrical machines such as electric motors are controlled by controllers that need to be configured for the control of the specific electrical machine at issue. This is achieved by installing a dataset onto the controller after identifying the electrical machine. This identification may be based on, for example, information contained in a visual format or a memory device attached to the machine. However, identifying a machine in the ways currently practiced may not be suitable in certain operational situations, may not fulfill the safety requirements of the particular application, and may be prone to human error.

To remedy this, systems, methods and other approaches are provided for determining a type of an electrical machine based on a signal representing an electrical current generated in the electrical machine. By using a current generated in the electrical machine, the electrical machine can be identified based on sensor signals and control hardware that are already available. The identification can be performed at standstill, which makes it suitable for different stages of operation. Once the machine is identified, an appropriate dataset for the controller can be selected, for example from a number of preloaded or downloaded datasets. If the signals are considered safe, it can be ensured that the correct dataset is properly selected, which is especially useful in safety critical applications where the integrity of the parameter choice is of utmost importance.

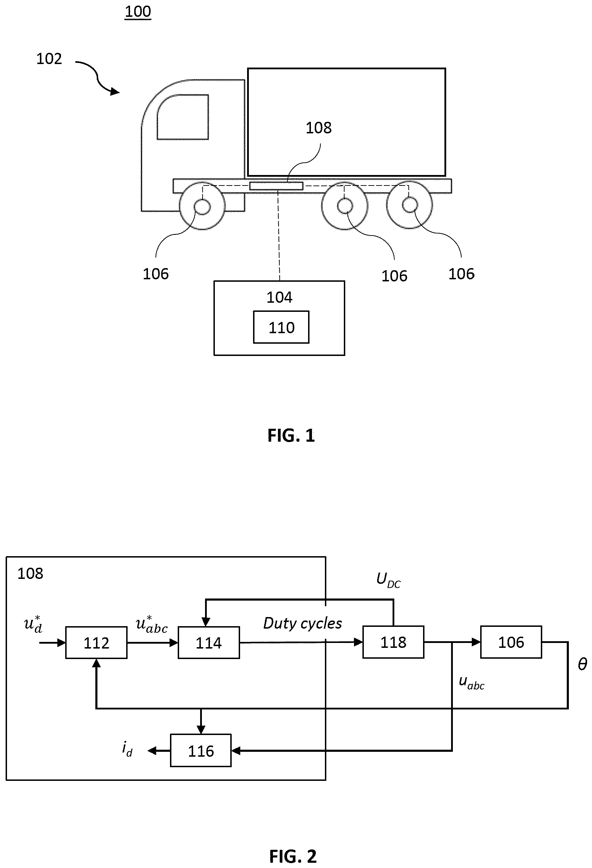

**FIG. 1** is a schematic diagram of a vehicle system **100** according to an example. The system **100** comprises a vehicle **102** and a computer system **104.**

The vehicle **102** may be any suitable form of vehicle. For example, the disclosure can be applied in heavy-duty vehicles, such as trucks, buses, and construction equipment, in personal vehicles such as cars, vans, or motorbikes, or in any other suitable form of vehicle. The vehicle may be a vehicle combination comprising a number of units, including a tractor unit and at least one trailing unit. The vehicle **102** comprises one or more electrical machines **106,** such as electric motors and/or generators. For example, one or more electric motors may drive one or more axles of the vehicle **102** to provide propulsion.

The electrical machines **106** may be controlled by controllers, such as microcontrollers. A controller **108** may be implemented in the vehicle **102. FIG. 1** shows a common controller **108** for all electrical machines **106** of the vehicle **102,** however it will be appreciated that each electrical machine **106** may have its own respective controller **108.** In many cases, the controller **108** may be implemented in the structure of the electrical machine **106** itself.

Each controller **108** may be configured for the control of the specific electrical machine **106** to which it is associated. For example, a controller **108** may be configured for embedded software control or monitoring. This is achieved by installing a dataset onto the controller **108.** The dataset may include control parameter settings that are specific to the type of electrical machine **106** being controlled. For example, a controller **108** may include settings for manual or automatic starting and stopping the electrical machine **106,** selecting forward or reverse rotation, selecting and regulating the speed, regulating or limiting the torque, and protecting against overloads and electrical faults. Generally, such a dataset is downloaded onto the controller **108** after identifying the electrical machine **106** to which it is associated. As such, the controller **108** is communicatively coupled to a computer system **104.**

The computer system **104** comprises processing circuitry **110.** The computer system may be a vehicle control unit configured to perform various vehicle (unit) control functions, such as vehicle motion management. The computer system **104** may be local to the electrical machine **106** and/or the controller **108** (e.g. implemented in the vehicle **102,** implemented in the structure of the electrical machine **106,** or implemented as a module of the controller **108** itself). Alternatively, the computer system **104** may be a remote system, implemented at a distance from the electrical machine **106** and/or the controller **108** (e.g. outside the vehicle **102).** The computer system **104** may be communicatively coupled to the controller **108** in any suitable way, for example via a circuit or any other wired, wireless, or network connection known in the art. Furthermore, the communicative coupling may be implemented as a direct connection between the computer system **104** and the controller **108,** or may be implemented as a connection via one or more intermediate entities.

Whilst the present disclosure is explained in relation to electrical machines of vehicles, it will be appreciated that the methods, systems and approaches disclosed herein could be applied to electrical machines having other uses and implementations.

As discussed above, an electrical machine **106** may be an electric motor or and electric generator. An electric motor converts electrical energy into mechanical energy. To operate an electric motor, a voltage is applied that causes a current to be generated in the windings of the motor. An interaction between the motor's magnetic field and the current generates a torque on the shaft of the motor. An electric generator operates in reverse, converting mechanical energy into electrical energy.

In the present disclosure, it is proposed to apply the voltage to the electrical machine **106** in the synchronous reference frame. The synchronous reference frame, also called the direct-quadrature or dq reference frame, converts grid voltage and current into a frame that rotates synchronously with the grid voltage vector by Clarke and Park Transformation methods so that three-phase time-varying abc signals are transformed into dq direct current (DC) signals. The synchronous reference frame can be defined as:

$$
\begin{bmatrix} i_d \\ i_q \\ i_0 \end{bmatrix} = \sqrt{\frac{2}{3}} \begin{bmatrix} \cos(\theta) & \cos\left(\theta - \frac{2\pi}{3}\right) & \cos\left(\theta + \frac{2\pi}{3}\right) \\ -\sin(\theta) & -\sin\left(\theta + \frac{2\pi}{3}\right) & -\sin\left(\theta + \frac{2\pi}{3}\right) \\ \frac{\sqrt{2}}{2} & \frac{\sqrt{2}}{2} & \frac{\sqrt{2}}{2} \end{bmatrix} \begin{bmatrix} i_a \\ i_b \\ i_c \end{bmatrix}
\tag{1}
$$

where $i_a$, $i_b$ and $i_c$ are the phase currents in the electrical machine **106**, $\theta$ is the rotor position of the electrical machine **106,** $i_d$ is the d current, $i_q$ is the q current, and $i_0$ is zero-sequence current, which is zero in a balanced system.

At standstill, the voltage equations of an electrical machine **106** can defined as:

$$
u_d = L_d \frac{di_d}{dt} + Ri_d
\tag{2}
$$

$$
u_q = L_q \frac{di_q}{dt} + Ri_q
\tag{3}
$$

where $u_d$ is the d voltage, $u_q$ is the q voltage, $L_d$ is the d inductance, $L_q$ is the q inductance, and R is the resistance. The electrical machine **106** can therefore be considered as two independent first order RL circuits where the currents can be controlled freely supposing that the voltages are fully controllable.

The torque, T, in the electrical machine **106** can be estimated by:

$$
T = \frac{3}{2} pp \left( i_q \psi_{pm} + i_d i_q \left( L_d - L_q \right) \right)
\tag{4}
$$

where $pp$ is the number of pole pairs in the electrical machine **106,** and $\psi_{pm}$ is the linked magnetic flux from permanent magnets.

Equation (4) shows that, if R and $L_d$ are approximately the same for a specific electrical machine **106** design, the response is predictable. Therefore, it is possible to distinguish between different electrical machines **106** (if their characteristics are known in advance) by analyzing the magnitude of current change as a function of voltage and time.

Further, equation (4) shows that a q current always generates torque, but that a d current can be applied freely without any torque generation if the q current is zero. Consequently, it is possible to generate a current response without generating any torque if a voltage is applied in d.

**FIG. 2** schematically shows part of the system **100** shown in **FIG. 1.** In particular, an electrical machine **106** and a controller **108** are shown in the form of functional blocks. The controller **108** comprises a dq/abc converter **112,** a pulse width modulator **114,** and an abc/dq converter **116.** In this example, a voltage is applied in d to generate a current response without generating any torque.

In operation, the dq/abc converter **112** receives a d voltage reference, $u_d^*$, for example directly from the computer system **104** or based on a signal from the computer system **104,** and outputs abc voltage references, $u_{abc}^*$.

The abc voltage references, $u_{abc}^*$, are fed to the pulse width modulator **114,** which also receives a DC-link voltage, $U_{DC}$, detected by sensors in an inverter **118.** The pulse width modulator **114** then produces duty cycles, which are fed to the inverter **118.** Based on the duty cycles and the DC-link voltage, $U_{DC}$, the inverter **118** produces abc voltages, $u_{abc}$, that are fed to the electrical machine **106.** The electrical machine **106** then produces a resultant rotor position, $\theta$, which is fed back to the dq/abc converter **112,** which uses the rotor position, $\theta$, to produce the abc voltage references, $u_{abc}^*$, using an inverse dq transformation. The rotor position, $\theta$, and the abc voltages, $u_{abc}$, are also fed to the abc/dq converter **116,** which produces a d current, $i_d$. The d current, $i_d$, can be compared to reference data for different types of electrical machine, as will be discussed below.

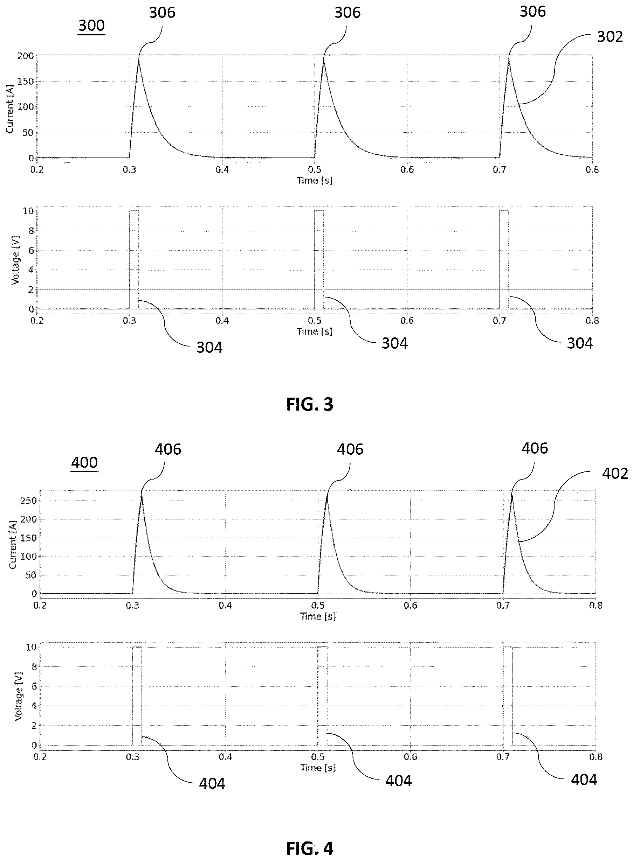

**FIG. 3** is an example plot **300** of the current response **302** for a plurality of reference voltage pulses **304** for a first type of electrical machine **106.** The reference voltage pulses **304** have a magnitude of 10V, a duration of 0.1s, and a frequency of 5Hz. As shown in **FIG. 3,** the current reaches a peak value **306** of around 200A for each voltage pulse **304.** In this context, the term "peak value" relates to the maximum current value for each voltage pulse, rather than maximum current value for the entire current response **302.** As the current decreases after each voltage pulse **304,** it can be seen that the derivative of the current response **302** decreases until the current reaches zero.

**FIG. 4** is an example plot **400** of the current response **402** for a plurality of reference voltage pulses **404** for a second type of electrical machine **106.** The reference voltage pulses **404** have the same magnitude, duration, and frequency as the voltage pulses **304** shown in **FIG. 3.** Compared to the current response **302** of the first type of electrical machine **106** shown **FIG. 3,** it can be seen that the current reaches a peak value **406** of around 250A for each voltage pulse **404.** Furthermore, the derivative of the current response **402** is generally higher than that of the current response **302** as the current decreases after each voltage pulse **404.** These differences between the current responses **302, 402** enable the different machines to be distinguished from each other based on a voltage impulse input. This information can be used in identifying a type of electrical machine **106** for the purposes of installing an appropriate dataset onto an associated controller.

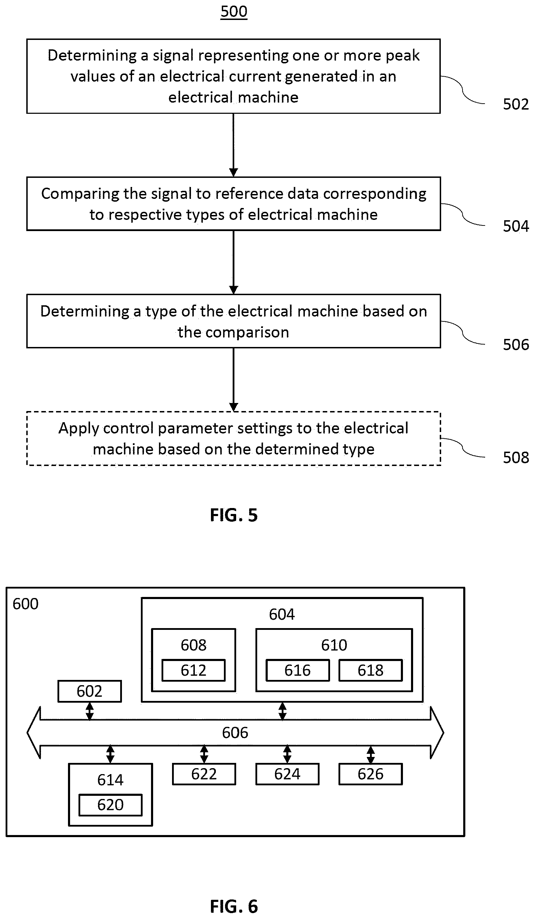

**FIG. 5** is a flow chart of a computer-implemented method **500** according to an example. The method **500** enables the identification of a type of an electrical machine **106** based on a voltage impulse input. In particular, the method **500** is based on investigating the change of current in an electrical machine **106** during a defined time when a defined voltage is applied to the windings of the electrical machine **106.** The method **500** may be implemented by processing circuitry of a computer system (e.g., the processing circuitry **110** of the computer system **104** described in relation to **FIG. 1).**

At **502,** a signal is received representing one or more peak values of an electrical current generated in an electrical machine. For example, the signal may be a current response **302, 402** as shown in **FIGs. 3** and **4,** and the peak values are the peak values **306, 406.**

As discussed above, to determine a current response **302, 402,** one or more reference voltage pulses **304, 404** may be applied to the electrical machine **106** to generate a current in the electrical machine **106.** By applying reference voltage pulses **304, 404** to the electrical machine **106,** the response of the electrical machine **106** can be compared to known and/or expected responses. The electrical current is generated in the windings of the electrical machine **106.** The signal may be determined or received from at least one sensor associated with the electrical machine **106,** for example sensors for detecting AC currents, DC-link voltage and rotor position. As such, the method **500** can be implemented using sensors that are already available in the system **100,** reducing the need for additional hardware and/or infrastructure. Furthermore, if the sensor signals are are considered to meet the relevant safety standard (e.g. having an Automotive Safety Integrity Level classed according to ISO26262), then the identification will in turn be considered safe, which ensures that the correct dataset is properly selected.

Any suitable number of voltage pulses **304, 404** may be applied, from one to many. Applying one pulse **304, 404,** and generating a single corresponding peak value **306, 406,** can provide a quicker approach that reduces wear in the electrical machine **106.** Applying two or more pulses **304, 404,** and generating a corresponding number of peak values **306, 406,** may provide more reliable results and a more robust identification. In the case that a plurality of voltage pulses **304, 404** are applied, an average of the plurality of peak values **306, 406** of the current may be determined. This can ensure that any anomalous values are compensated for. However, it should be ensured the number of pulses **304, 404** is sufficiently limited so that heat build-up in the inverter **118** and/or the electrical machine **106** is avoided.

The frequency of the voltage pulses **304, 404** may also be selected carefully. For example, the frequency can be selected such that there is sufficient time between pulses **304, 404** that the derivative of the current response **302, 402** starts to decrease. The purpose of doing this is to enable the effect of the resistance and the inductance to be included in the identification of the electrical machine **106,** as will be discussed below. Including further variables in the process renders the identification more robust. Furthermore, the frequency of the voltage pulses **304, 404** can be synchronized with a modulation provided by the pulse width modulator **114.** As such, the time offset between the application of voltage pulse **304, 404** and each a corresponding peak current value **306, 406** can be estimated accurately. Furthermore, the frequency of the voltage pulses **304, 404** can be selected such that there is sufficient rest time between the pulses **304, 404** to avoid heat building up in the inverter **118** and the electrical machine **106.** In general, it may be desired that that generation of the current response **302, 402** is performed in a controlled environment, to ensure that the temperatures of the inverter **118** and the electrical machine **106** are at, or at least close to, room temperature. This helps to avoid variation in the resistance of the power modules of the inverter **118** or the windings of the electrical machine **106.**

A suitable schedule for the voltage pulses **304, 404,** including voltage magnitude, pulse duration, and frequency, can be determined for each relevant machine type of electrical machine **106** to generate suitable current responses. Such schedules can be determined through testing, experiments, and the like. Furthermore, the same parameters for the dq/abc converter **112,** the pulse width modulator **114,** and the abc/dq converter **116** that will be used when the method **500** is implemented can be used when determining the schedules. This ensures that non-linearities of the electrical machine **106,** the dq/abc converter **112,** the pulse width modulator **114,** and the abc/dq converter **116** that are difficult to estimate theoretically can be accounted for when performing the identification.

In some examples, the one or more reference voltage pulses **304, 404** can be applied to the electrical machine **106** such that the electrical machine **106** does not generate torque. As discussed above, this can be achieved by applying a voltage in d. Performing the method **500** without any torque generation makes it ideal for an end-of line testing or when the electrical machine **106** is installed in the vehicle **102,** and reduces wear in the electrical machine **106.**

At **504,** the signal is compared to reference data. The reference data comprises a one or more sets of reference data, each corresponding to a particular type of electrical machine **106.** For example, a set of reference data may comprise a number of scalar current values corresponding to scalar voltage values for a particular electrical machine **106,** indicating the expected current response for a voltage pulse of a given magnitude in that machine. This may provide a quick and easy comparison to be performed. In another example, a set of reference data may comprise a characteristic curve or temporal evolution of the current response of a particular electrical machine **106** to a number of voltage pulses of a given magnitude. As discussed above, the derivative of a current response is affected by the resistance and the inductance of the electrical machine **106,** and therefore comparing the response to a characteristic curve or temporal evolution can provide further distinction between different types of electrical machine **106.** The reference data may be predefined, for example data captured from testing, experiments, and the like.

In some examples, a single set of reference data may be used, for example if it is desired to confirm an already-known machine type of the electrical machine **106.** In other examples, a plurality of sets of reference data may be used, enabling identification of a type of the electrical machine **106** from a number of different types of machine, for example when the machine type is unknown.

In one example, a peak value **306, 406** or an average of a plurality of peak values **306, 406** may be compared to a single scalar reference value. In another example, the current response **302, 402** may be compared to a characteristic curve. For example, peak value **306, 406** or an average of a plurality of peak values **306, 406** may be compared to one or more peaks in the characteristic curve. The comparison at **504** may involve determining a set of reference data that has the smallest difference to the signal. In one example, this can be done by determining the difference between a peak value **306, 406** or average of a plurality of peak values **306, 406** and the corresponding scalar reference value for each set of reference data, and determining which set of reference data has the smallest distance to the peak value. In another example, curve matching or analysis techniques known in the art may be used to compare a current response **302, 402** to a characteristic curve value for each set of reference data, and determine which set of reference data is the closest to the current response **302, 402.** In this way, the set of reference data having a reference peak value closest to the determined peak value can be identified. This enables the most accurate match for the machine type to be determined.

At **506,** a type of the electrical machine **106** is determined based on the comparison at **504.** For example, as discussed above, a set of reference data that has the smallest difference to the signal may be identified. As each set of reference data corresponds to a particular type of electrical machine **106,** the type of electrical machine **106** can be identified by the comparison.

Identifying a type of electrical machine in this way provides an accurate result that can be performed using existing hardware. The determination of a current response can be performed robustly and in a simple manner by applying a number of voltage pulses. The timing and magnitude of the voltage pulses can be tailored to provide different information about the current response of the machine, providing a yet more robust identification. The use of existing hardware removes the need for additional components and/or infrastructure, and ensures that the relevant safety requirements are met. This approach also avoids any manual identification which is prone to human error.

The method **500** offers an empirical way to study the behaviour of an electrical machine. It is also possible to theoretically predict the current response of an electrical machine **106** to a specific voltage pulse if the machine parameters, for example the resistance and the inductance, are known. However, due to non-linearities of machine behavior, it is generally better to derive the current response empirically and perform the identification accordingly. Both methods may be applied in the disclosed implementation.

At optional step **508,** control parameter settings may be applied to the electrical machine **106** based on the determined type. In particular, a dataset including control parameter settings may be installed onto the controller **108.** As discussed above, the control parameter settings may include settings for manual or automatic starting and stopping the electrical machine **106,** selecting forward or reverse rotation, selecting and regulating the speed, regulating or limiting the torque, and protecting against overloads and electrical faults. In some embodiment, a plurality of datasets may be preloaded or downloaded onto the controller **108,** and a particular one of the datasets may be selected based on the identification. This ensures that datasets can be loaded onto the controller **108** when data connectivity is sufficient, and avoids the need to download datasets reactively, which may not be favorable. The method **500** enables proper identification of a type of electrical machine **106** so that the appropriate dataset can be applied.

FIG. 6 is a schematic diagram of a computer system **600** for implementing examples disclosed herein. The computer system **600** is adapted to execute instructions from a computer-readable medium to perform these and/or any of the functions or processing described herein. The computer system **600** may be connected (e.g., networked) to other machines in a LAN, an intranet, an extranet, or the Internet. While only a single device is illustrated, the computer system **600** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include processing circuitry **602** (e.g., processing circuitry including one or more processor devices or control units), a memory **604,** and a system bus **606.** The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610,** which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614,** which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface **626** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

According to certain examples, there is also disclosed:

Example 1: A computer system (104) comprising processing circuitry (110) configured to: receive a signal (302, 402) representing one or more peak values (306, 406) of an electrical current generated in an electrical machine (106); compare the signal (302, 402) to reference data corresponding to respective types of electrical machine; and determine a type of the electrical machine (106) based on the comparison.

Example 2: The computer system (104) of example 1, wherein the signal (302, 402) represents a single peak value (306, 406) of an electrical current generated in the electrical machine (106).

Example 3: The computer system (104) of example 1, wherein the signal (302, 402) represents a plurality of peak values (306, 406) of an electrical current generated in the electrical machine (106).

Example 4: The computer system (104) of example 3, wherein the processing circuitry (110) is further configured to determine an average peak value of the plurality of peak values (306, 406), and compare the average peak value to the reference data.

Example 5: The computer system (104) of any of preceding example, wherein the reference data comprises one or more sets of reference data wherein each set of reference data corresponds to a respective type of electrical machine.

Example 6: The computer system (104) of example 5, wherein the processing circuitry (110) is further configured to: compare the signal (302, 402) to a plurality of sets of reference data; and determine a set of reference data of the plurality of sets of reference data having a smallest difference to the signal (302, 402).

Example 7: The computer system (104) of any of preceding example, wherein each set of reference data comprises at least one scalar current value corresponding to at least one scalar voltage value and/or at least one characteristic curve of a current response to one or more voltage pulses.

Example 8: The computer system (104) of any preceding example, wherein the processing circuitry (110) is further configured to apply one or more reference voltage pulses (304, 404) to the electrical machine (106) to generate the current in the electrical machine (106).

Example 9: The computer system (104) of example 8, wherein the processing circuitry (110) is configured to apply the one or more reference voltage pulses (304, 404) to the electrical machine (106) such that the electrical machine (106) does not generate torque.

Example 10: The computer system (104) of any of preceding example, wherein the processing circuitry (110) is configured to determine the signal (302, 402) based on an output from at least one sensor associated with the electrical machine (106).

Example 11: The computer system (104) of any of preceding example, wherein the processing circuitry (110) is further configured to apply control parameter settings to the electrical machine (106) based on the determined type.

Example 12: A vehicle (102) comprising the computer system (104) of any preceding example.

Example 13: A computer-implemented method (500), comprising receiving (502), by processing circuitry (110) of a computer system (104), a signal (302, 402) representing one or more peak values (306, 406) of an electrical current generated in an electrical machine (106), comparing (504), by the processing circuitry (110), the signal (302, 402) to reference data corresponding to respective types of electrical machine, and determining (506), by the processing circuitry (110), a type of the electrical machine (106) based on the comparison.

Example 14: The computer-implemented method (500) of example 13, wherein the signal (302, 402) represents a single peak value (306, 406) of an electrical current generated in the electrical machine (106).

Example 15: The computer-implemented method (500) of example 13, wherein the signal (302, 402) represents a plurality of peak values (306, 406) of an electrical current generated in the electrical machine (106).

Example 16: The computer-implemented method (500) of example 15, further comprising, by the processing circuitry (110), determining an average peak value of the plurality of peak values (306, 406), and comparing the average peak value to the reference data.

Example 17: The computer-implemented method (500) of any of examples 13 to 16, wherein the reference data comprises one or more sets of reference data wherein each set of reference data corresponds to a respective type of electrical machine.

Example 18: The computer-implemented method (500) example 17, further comprising, by the processing circuitry (110), comparing the signal (302, 402) to a plurality of sets of reference data; and determining a set of reference data of the plurality of sets of reference data having a smallest difference to the signal (302, 402).

Example 19: The computer-implemented method (500) of any of examples 13 to 18, wherein each set of reference data comprises at least one scalar current value corresponding to at least one scalar voltage value and/or at least one characteristic curve of a current response to one or more voltage pulses.

Example 20: The computer-implemented method (500) of any of examples 13 to 19, further comprising, by the processing circuitry (110), applying one or more reference voltage pulses (304, 404) to the electrical machine (106) to generate the current in the electrical machine (106).

Example 21: The computer-implemented method (500) of example 20, further comprising, by the processing circuitry (110), applying the one or more reference voltage pulses (304, 404) to the electrical machine (106) such that the electrical machine (106) does not generate torque.

Example 22: The computer-implemented method (500) of any of examples 13 to 21, further comprising, by the processing circuitry (110), determining the signal (302, 402) based on an output from at least one sensor associated with the electrical machine (106).

Example 23: The computer-implemented method (500) of any of examples 13 to 22, further comprising, by the processing circuitry (110), applying control parameter settings to the electrical machine (106) based on the determined type.

Example 24: A computer program product comprising program code for performing, when executed by processing circuitry (110), the computer-implemented method (500) of any of examples 13 to 23.

Example 25: A non-transitory computer-readable storage medium comprising instructions, which when executed by processing circuitry (110), cause the processing circuitry (110) to perform the computer-implemented method (500) of any of examples 13 to 23.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1.  A computer system (104) comprising processing circuitry (110) configured to:

    receive a signal (302, 402) representing one or more peak values (306, 406) of an electrical current generated in an electrical machine (106);
    compare the signal (302, 402) to reference data corresponding to respective types of electrical machine; and
    determine a type of the electrical machine (106) based on the comparison.

2.  The computer system (104) of claim 1, wherein the signal (302, 402) represents a single peak value (306, 406) of an electrical current generated in the electrical machine (106).

3.  The computer system (104) of claim 1, wherein the signal (302, 402) represents a plurality of peak values (306, 406) of an electrical current generated in the electrical machine (106).

4.  The computer system (104) of claim 3, wherein the processing circuitry (110) is further configured to determine an average peak value of the plurality of peak values (306, 406), and compare the average peak value to the reference data.

5.  The computer system (104) of any of preceding claim, wherein the reference data comprises one or more sets of reference data wherein each set of reference data corresponds to a respective type of electrical machine.

6.  The computer system (104) of claim 5, wherein the processing circuitry (110) is further configured to:

    compare the signal (302, 402) to a plurality of sets of reference data; and
    determine a set of reference data of the plurality of sets of reference data having a smallest difference to the signal (302, 402).

7.  The computer system (104) of any of preceding claim, wherein each set of reference data comprises at least one scalar current value corresponding to at least one scalar voltage value and/or at least one characteristic curve of a current response to one or more voltage pulses.

8.  The computer system (104) of any preceding claim, wherein the processing circuitry (110) is further configured to apply one or more reference voltage pulses (304, 404) to the electrical machine (106) to generate the current in the electrical machine (106).

9.  The computer system (104) of claim 8, wherein the processing circuitry (110) is configured to apply the one or more reference voltage pulses (304, 404) to the electrical machine (106) such that the electrical machine (106) does not generate torque.

10. The computer system (104) of any of preceding claim, wherein the processing circuitry (110) is configured to determine the signal (302, 402) based on an output from at least one sensor associated with the electrical machine (106).

11. The computer system (104) of any of preceding claim, wherein the processing circuitry (110) is further configured to apply control parameter settings to the electrical machine (106) based on the determined type.

12. A vehicle (102) comprising the computer system (104) of any preceding claim.

13. A computer-implemented method (500), comprising:

receiving (502), by processing circuitry (110) of a computer system (104), a signal (302, 402) representing one or more peak values (306, 406) of an electrical current generated in an electrical machine (106);
comparing (504), by the processing circuitry (110), the signal (302, 402) to reference data corresponding to respective types of electrical machine; and
determining (506), by the processing circuitry (110), a type of the electrical machine (106) based on the comparison.

14. A computer program product comprising program code for performing, when executed by processing circuitry (110), the computer-implemented method (500) of claim 13.

15. A non-transitory computer-readable storage medium comprising instructions, which when executed by processing circuitry (110), cause the processing circuitry (110) to perform the computer-implemented method (500) of claim 13.

**Amended claims in accordance with Rule 137(2) EPC.**

1. A computer system (104) comprising processing circuitry (110) configured to:

receive a signal (302, 402) representing one or more peak values (306, 406) of an electrical current generated in an electrical machine (106);
compare the signal (302, 402) to one or more sets of reference data, wherein each set of reference data corresponds to a respective type of electrical machine, and wherein each set of reference data comprises at least one characteristic curve of a current response to one or more voltage pulses; and
determine a type of the electrical machine (106) based on the comparison.

2. The computer system (104) of claim 1, wherein the signal (302, 402) represents a single peak value (306, 406) of an electrical current generated in the electrical machine (106).

3. The computer system (104) of claim 1, wherein the signal (302, 402) represents a plurality of peak values (306, 406) of an electrical current generated in the electrical machine (106).

4. The computer system (104) of claim 3, wherein the processing circuitry (110) is further configured to determine an average peak value of the plurality of peak values (306, 406), and compare the average peak value to the reference data.

5. The computer system (104) of any preceding claim, wherein the processing circuitry (110) is further configured to:

compare the signal (302, 402) to a plurality of sets of reference data; and
determine a set of reference data of the plurality of sets of reference data having a smallest difference to the signal (302, 402).

6. The computer system (104) of any of preceding claim, wherein each set of reference data comprises at least one scalar current value corresponding to at least one scalar voltage value.

7. The computer system (104) of any preceding claim, wherein the processing circuitry (110) is further configured to apply one or more reference voltage pulses (304, 404) to the electrical machine (106) to generate the current in the electrical machine (106).

8.  The computer system (104) of claim 7, wherein the processing circuitry (110) is configured to apply the one or more reference voltage pulses (304, 404) to the electrical machine (106) such that the electrical machine (106) does not generate torque.

9.  The computer system (104) of any of preceding claim, wherein the processing circuitry (110) is configured to determine the signal (302, 402) based on an output from at least one sensor associated with the electrical machine (106).

10. The computer system (104) of any of preceding claim, wherein the processing circuitry (110) is further configured to apply control parameter settings to the electrical machine (106) based on the determined type.

11. A vehicle (102) comprising the computer system (104) of any preceding claim.

12. A computer-implemented method (500), comprising:

    receiving (502), by processing circuitry (110) of a computer system (104), a signal (302, 402) representing one or more peak values (306, 406) of an electrical current generated in an electrical machine (106);
    comparing (504), by the processing circuitry (110), the signal (302, 402) to one or more sets of reference data, wherein each set of reference data corresponds to a respective type of electrical machine, and wherein each set of reference data comprises at least one characteristic curve of a current response to one or more voltage pulses; and
    determining (506), by the processing circuitry (110), a type of the electrical machine (106) based on the comparison.

13. A computer program product comprising program code for performing, when executed by processing circuitry (110), the computer-implemented method (500) of claim 12.

14. A non-transitory computer-readable storage medium comprising instructions, which when executed by processing circuitry (110), cause the processing circuitry (110) to perform the computer-implemented method (500) of claim 12.

<u>100</u>

**FIG. 1**

**FIG. 2**

**FIG. 3**

**FIG. 4**

500

| Determining a signal representing one or more peak values of an electrical current generated in an electrical machine | 502 |

| Comparing the signal to reference data corresponding to respective types of electrical machine | 504 |

| Determining a type of the electrical machine based on the comparison | 506 |

| Apply control parameter settings to the electrical machine based on the determined type | 508 |

FIG. 5

600

604

608

612

610

616    618

602

606

614

620

622    624    626

FIG. 6

**EUROPEAN SEARCH REPORT**

Application Number

EP 23 20 7987

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/119675 A1 (TANAKA YUYA [JP] ET AL) 16 April 2020 (2020-04-16) * the whole document * ----- | 1-15 | INV. H02P21/00 G01R31/34 H02P21/14 |
| A | US 2010/060210 A1 (LIU JINGBO [US] ET AL) 11 March 2010 (2010-03-11) * the whole document * ----- | 1-15 | |
| A | US 9 221 480 B2 (GEN ELECTRIC [US]) 29 December 2015 (2015-12-29) * the whole document * ----- | 1-15 | |

TECHNICAL FIELDS
SEARCHED      (IPC)

H02P
G01R

The present search report has been drawn up for all claims

| Place of search | Date of completion of the search | Examiner |
|---|---|---|
| Munich | 18 April 2024 | Wimböck, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.......................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 20 7987

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2024

| Patent document cited in search report | | Publication date | Patent family member(s) | | Publication date |
|---|---|---|---|---|---|
| US 2020119675 | A1 | 16-04-2020 | NONE | | |
| US 2010060210 | A1 | 11-03-2010 | NONE | | |
| US 9221480 | B2 | 29-12-2015 | JP | 6524464 B2 | 05-06-2019 |
| | | | JP | 2015133898 A | 23-07-2015 |
| | | | US | 2015191183 A1 | 09-07-2015 |
| | | | US | 2016082990 A1 | 24-03-2016 |

EPO FORM P0459

For more details about this annex : see Official Journal of the European Patent Office, No. 12/82